# EUROPÄISCHE PATENTSCHRIFT

(11) **EP 3 685 424 B1**
(45) Veröffentlichungstag und Bekanntmachung des Hinweises auf die Patenterteilung: **20.04.2022**
(21) Anmeldenummer: 18782324.0
(22) Anmeldetag: 17.09.2018
(51) Int. Cl.: H01J 37/32, A23L 3/01, H05B 6/70

(54) **VORRICHTUNG ZUR BEHANDLUNG EINES PRODUKTS MIT MIKROWELLEN**
DEVICE FOR TREATING A PRODUCT WITH MICROWAVES
DISPOSITIF POUR TRAITER UN PRODUIT AU MOYEN DE MICRO-ONDES

(30) Priorität: 19.09.2017 DE 102017121731
(43) Veröffentlichungstag der Anmeldung: 29.07.2020
(73) Patentinhaber: Muegge GmbH, 64385 Reichelsheim (DE)
(72) Erfinder: BAARS, Daniel, 64407 Fränkisch-Crumbach (DE); REICHMANN, Markus, 64720 Michelstadt-Rehbach (DE); BAUMGÄRTNER, Klaus-Martin, 64395 Brensbach (DE); VOIT, Niko, 64750 Lützelbach (DE)
(74) Vertreter: Habermann Intellectual Property Partnerschaft von Patentanwälten mbB
(86) Internationale Anmeldenummer: PCT/EP2018/075065
(87) Internationale Veröffentlichungsnummer: WO 2019/057662

(56) Entgegenhaltungen:
- WO-A1-00/75955
- US-A1- 2008 053 988

## Beschreibung

Die Erfindung betrifft eine Vorrichtung zur Behandlung eines Produkts mit Mikrowellen, wobei die Vorrichtung einen Behandlungsraum, in welchem das Produkt längs einer Transportbahn in einer Transportrichtung durch den Behandlungsraum befördert werden kann, und eine in dem Behandlungsraum angeordnete Mikrowellenabstrahlung aufweist, mit welcher in die Mikrowellenabstrahleinrichtung abgekoppelte Mikrowellen abgestrahlt werden können, die auf das Produkt einwirken.

Es ist aus der Praxis bekannt, dass Mikrowellen zur Erwärmung von Produkten, beispielsweise von Lebensmitteln und zubereiteten Speisen verwendet werden können. Zu diesem Zweck werden Mikrowellen mit einer geeigneten Mikrowellenfrequenz in einen Behandlungsraum abgestrahlt, in dem sich das zu erwärmende Produkt befindet. Die in den Behandlungsraum abgestrahlten und in das dort befindlich Produkt eindringenden Mikrowellen erzeugen in dem Produkt Wärme, wobei die Erwärmung beispielsweise durch die eingestrahlte Mikrowellenleistung und durch die Dauer der Mikrowelleneinstrahlung vorgeben bzw. variiert werden kann.

Es ist ebenfalls bekannt, dass Mikrowellen zur Erwärmung industrieller Produkte während eines Herstellungsvorgangs oder einer Weiterverarbeitung der Produkte verwendet werden können. Mikrowellen können auch zur Sterilisierung und Haltbarmachung von Nahrungsmitteln oder Fertiggerichten verwendet werden, da mit einer ausreichend intensiven Mikrowelleneinstrahlung innerhalb kurzer Zeit eine sehr starke Erwärmung von Produkten möglich ist.

Bei aus der Praxis bekannten Behandlungsvorrichtungen kann die Mikrowelle über Hohlleiter in einen Behandlungsraum eingekoppelt werden, in welchem das zu behandelnde Produkt angeordnet ist. Der Behandlungsraum kann in Abhängigkeit von der verwendeten Mikrowellenfrequenz geeignete Abmessungen aufweisen, sodass der Behandlungsraum einen Resonator bildet und die Ausbildung von stehenden Wellen im Behandlungsraum ermöglicht bzw. begünstigt. Es wird jedoch als ein erheblicher Nachteil empfunden, dass bei räumlich ausgedehnten Produkten in derartigen Behandlungsräumen regelmäßig nur eine ungleichmäßige Erwärmung eines Produkts möglich ist, da die räumliche Verteilung der Mikrowellenergie innerhalb des Behandlungsraums insbesondere bei der Ausbildung von stehenden Wellen sehr ungleichmäßig ist.

Es ist ebenfalls aus der Praxis bekannt, dass die Mikrowellen über Hornstrahler in den Behandlungsraum eingekoppelt bzw. in dem Behandlungsraum auf das Produkt gerichtet abgestrahlt werden können. Auch bei derartigen Behandlungsvorrichtungen wird oftmals eine vergleichsweise ungleichmäßige Erwärmung eines in dem Behandlungsraum angeordneten Produkts festgestellt.

Aus DE 101 57 601 B4 ist eine Vorrichtung zur Behandlung eines Produkts mit Mikrowellen bekannt, bei der eine in dem Behandlungsraum angeordnete Mikrowellenabstrahleinrichtung eine Stabantenne aufweist, entlang der sich eine eingekoppelte Mikrowellenstrahlung ausbreitet und dabei radial in die Umgebung der Stabantenne abgestrahlt wird. Durch geeignet angeordnete Abschirmungen kann ein Anteil der Mikrowellenstrahlung, der von der Stabantenne in eine von dem Produkt abgewandten Richtung abgestrahlt wird, reflektiert und in Richtung des Produkts zurückgerichtet werden. Auf diese Weise kann ein vergleichsweise hoher Anteil der Mikrowellenstrahlung auf das Produkt gerichtet und zur Behandlung des Produkts verwendet werden. Durch die Verwendung der Stabantenne wird in axialer Richtung eine Ausbreitung der Mikrowellen längs der Stabantenne begünstigt und dadurch über eine axiale Erstreckung der Stabantenne hinweg die Abstrahlung von Mikrowellen in den Behandlungsraum ermöglicht, wobei diese Erstreckung deutlich größer als bei Hornstrahlern sein kann. Es hat sich jedoch gezeigt, dass auch bei der Verwendung einer Stabantenne die eingekoppelten Mikrowellen in axiale Richtungen längs der Stabantenne eine ungleichmäßige Mikrowellenabstrahlung erzeugen und ein benachbart zu der Stabantenne angeordnetes Produkt entsprechend ungleichmäßig erwärmt bzw. behandelt wird. Weitere Mikrowellenvorrichtungen zum homogenen Abstrahlen der Mikrowellenleistung sind aus WO 00/75955 A1 und US 2008/053988 A1 bekannt.

Durch eine Bewegung des Produkts auf der Transportbahn, die während der Behandlung mit den Mikrowellen stattfindet, wird die Problematik einer ungleichmäßigen Erwärmung des Produkts nicht reduziert. Vielmehr wirken während der Verlagerung des Produkts Mikrowellen auf das Produkt ein, die beim Eindringen in das Produkt von der Mikrowellenabstrahleinrichtung einen sich ständig ändernden Abstand aufweisen und deshalb in ständig unterschiedlicher Intensität auf das Produkt einwirken. Selbst bei geometrisch einfachen Mikrowellenabstrahleinrichtungen und bei Vernachlässigung von Reflexionen oder Streueffekten innerhalb des Behandlungsraums treten oftmals komplexe Intensitätsverteilungen der in den Behandlungsraum austretenden Mikrowellen auf, die eine gleichmäßige Behandlung des sich längs der Transportbahn bewegenden Produkts erschweren. Im Hinblick auf einen möglichst großen Produktdurchsatz während einer möglichst geringen Betriebsdauer der Vorrichtung wäre ein kontinuierlich verlaufender Transport von mehreren Produkten hintereinander durch den Behandlungsraum wünschenswert.

Es wird als eine Aufgabe der vorliegenden Erfindung angesehen, eine Vorrichtung mit einer durch den Behandlungsraum geführten Transportbahn zur Behandlung von darauf angeordneten Produkten mit Mikrowellen so auszugestalten, dass die zu behandelnden Produkte mit möglichst geringem Aufwand möglichst gleichmäßig durch die abgestrahlten Mikrowellen erwärmt werden können. Dabei soll nach Möglichkeit auch ein inhomogenes Produkt, das Bereiche mit unterschiedlicher Zusammensetzung aufweist, mit einfachen Mitteln möglichst gleichmäßig erwärmt werden können.

Dies Aufgabe wird erfindungsgemäß durch eine Vorrichtung gemäß Anspruch 1 gelöst. Weitere erfindungsgemäße Ausführungen sind in den abhängigen Ansprüchen ausgeführt. Eine in den Koaxialleiter eingekoppelte Mikrowelle kann sich in dem Koaxialleiter über die gesamte Länge bzw. axiale Erstreckung des Koaxialleiters ausbreiten. Dabei kann zwischen dem elektrisch leitenden Innenleiter und dem elektrisch leitenden Außenleiter ein dielektrisches Material und insbesondere ein dielektrischer Festkörper angeordnet sein, der eine hohe Permittivität aufweist und eine geringe dielektrische Verlustleistung für die sich in dem Koaxialleiter ausbreitenden Mikrowellen erzeugt. Durch die mindestens eine Öffnung können die sich zunächst in dem Koaxialleiter ausbreitenden Mikrowellen aus dem Koaxialleiter durch die betreffende Öffnung austreten und von dem Koaxialleiter abgestrahlt werden. Durch die Anordnung und die Abmessung der mindestens einen Öffnung kann eine auf das Produkt gerichtete Abstrahlung der austretenden Mikrowellen und dadurch eine effektive und gezielte Behandlung bzw. Erwärmung des Produkts erfolgen. Es ist vorteilhaft, dass der Koaxialleiter hinsichtlich seiner Abmessungen derart auf die eingekoppelten Mikrowellen und insbesondere auf die Frequenz der eingekoppelten Mikrowellen abgestimmt ist, dass sich in dem Koaxialleiter eine stehende Welle ausbildet. Die eine Öffnung oder die mehreren Öffnungen können in vorteilhafter Weise jeweils in einem Bereich eines elektrischen Feldstärkeknotens der stehenden Welle angeordnet sein, da dort eine besonders effektive Abstrahlung von Mikrowellen durch die betreffende Öffnung erfolgen kann.

Wenn der Koaxialleiter mehrere Öffnungen aufweist, sind die Öffnungen zweckmäßigerweise etwa eine halbe Wellenlänge der Wellenlänge der in den Koaxialleiter eingekoppelten Mikrowellen oder ein ganzzeiliges Vielfaches davon voneinander beabstandet, um eine effektive Auskopplung der in den Koaxialleiter eingekoppelten Mikrowellen durch alle Öffnungen zu ermöglichen. Jede einzelne Öffnung weist in axialer Richtung eine Ausdehnung von einer Viertel Wellenlänge oder zumindest weniger als eine halbe Wellenlänge der in den Koaxialleiter eingekoppelten Mikrowellen auf. Eine Öffnung erstreckt sich in Umfangsrichtung des Koaxialleiters über weniger als einen halben Umfang, wobei bei einem größeren Öffnungswinkel eine höhere Mikrowellenleistung durch die Öffnung abgestrahlt werden kann, die jedoch durch einen kleineren Öffnungswinkel besser fokussiert und stärker auf das Produkt gerichtet werden kann.

Optional kann in einem Innenraum zwischen dem Innenleiter und dem Außenleiter ein hohlzylinderförmiger dielektrischer Festkörper angeordnet sein, dessen Permittivität größer als die Permittivität von Luft ist. Der dielektrische Festkörper weist in zweckmäßiger Weise bei der für den Betrieb vorgesehenen Mikrowellenfrequenz einen möglichst geringen dielektrischen Verlustfaktor auf. Durch den hohlzylinderförmigen dielektrischen Festkörper wird der Innenraum zwischen dem Innenleiter und dem Außenleiter im Wesentlichen vollständig ausgefüllt. Allerdings ist es sowohl aus Toleranzgründen als auch wegen der unterschiedlichen thermischen Ausdehnungskoeffizienten des Materials des Innenleiters und des Außenleiters einerseits und des dielektrischen Festkörpers andererseits zweckmäßig, dass zumindest um den Innenleiter herum ein kleiner Schlitz verbleibt. Der dielektrische Festkörper weist in radialer Richtung einen geringen Abstand zumindest zu dem Innenleiter und gegebenenfalls auch zu dem Außenleiter auf, sodass der dielektrische Festkörper entweder über die gesamte Umfangsfläche oder zumindest bereichsweise einen geringen Abstand zu dem Innenleiter bzw. gegebenenfalls stattdessen oder zusätzlich zu dem Außenleiter aufweist.

Im Hinblick auf eine möglichst effiziente Abstrahlung der Mikrowellen durch die Öffnung ist es vorteilhaft, dass der dielektrische Festkörper im Bereich der mindestens einen Öffnung eine nach innen ragende oder nach außen vorspringende Ausformung aufweist. Durch einen geeigneten Konturverlauf des dielektrischen Festkörpers im Bereich der Öffnung und insbesondere in einem Übergangsbereich längs eines Umfangsrands der Öffnung kann eine Eingangsimpedanz des Koaxialleiters auf eine Ausgangsimpedanz des umgebenden Mediums in dem Behandlungsraum abgestimmt werden, um eine möglichst vorteilhafte Auskopplung der Mikrowellen aus dem Koaxialleiter in den Behandlungsraum zu ermöglichen.

Durch die Anordnung und Ausgestaltung der mindestens einen Öffnung, zweckmäßigerweise jedoch der zwei oder mehr Öffnungen in dem Koaxialleiter kann die aus dem Koaxialleiter in Richtung des Produkts abgestrahlte Mikrowellenleistung an das zu behandelnde Produkt angepasst werden, um eine möglichst gleichmäßige Erwärmung des Produkts zu ermöglichen, wenn das Produkt längs der Transportbahn in der Transportrichtung an dem Koaxialleiter vorbeibefördert wird.

Gemäß der Erfindung ist vorgesehen, dass die Mikrowellenabstrahleinrichtung mehrere in Transportrichtung der Transportbahn beabstandet zueinander angeordnete Koaxialleiter mit mindestens einer Öffnung in dem jeweiligen Außenleiter aufweist. Die mehreren Koaxialleiter sind in vorteilhafter Weise quer zu der Transportrichtung angeordnet und ragen von einer Seitenkante der Transportbahn bis zu der gegenüberliegenden Seitenkante, so dass die quer zu der Transportrichtung ausgerichteten Koaxialleiter jeweils eine Breite der Transportbahn vollständig abdecken können. Ein an den Koaxialleitern auf der Transportbahn vorbeibefördertes Produkt wird von jedem Koaxialleiter mit Mikrowellen bestrahlt, so dass die von jedem Koaxialleiter abgestrahlte Mikrowellenleistung einen Anteil zur Behandlung des Produkts mit Mikrowellen beiträgt. Die einzelnen Koaxialleiter können hinsichtlich der durch jeden Koaxialleiter abgestrahlten Mikrowellenleistung an die insgesamt gewünschte bzw. vorgegebene Mikrowellenleistung angepasst werden, die für das betreffende Produkt erforderlich ist. Für ein anderes Produkt, das lediglich eine geringere Mikrowellenleistung für dessen Behandlung erfordert, können beispielsweise einzelne Koaxialleiter abgeschaltet bzw. nicht mit eingekoppelten Mikrowellen versorgt werden.

Gemäß der Erfindung ist vorgesehen, dass bei einem in Transportrichtung nachfolgend angeordneten Koaxialleiter die mindestens eine Öffnung quer zur Transportrichtung versetzt relativ zu der mindestens einen Öffnung eines vorausgehenden Koaxialleiters angeordnet ist. Durch eine versetzte Anordnung der in Transportrichtung aufeinanderfolgenden Öffnungen der mehreren Koaxialleiter kann über die gesamte Breite der Transportbahn eine aus mehreren Öffnungen zusammengesetzte Mikrowellenabstrahlung erzeugt und für die Behandlung des Produkts verwendet werden. Die einzelnen Öffnungen können dabei in axialer Richtung der Koaxialleiter bzw. quer zu der Transportrichtung der Transportbahn eine vergleichsweise geringe Ausdehnung aufweisen. Sofern eine ausreichende Anzahl von Koaxialleitern hintereinander angeordnet ist und die jeweiligen Öffnungen der nachfolgenden Koaxialleiter versetzt zu den Öffnungen der vorausgehenden Koaxialleitern angeordnet sind, kann durch die mehreren hintereinander und seitlich zueinander versetzt angeordneten Öffnungen die gesamte Breite der Transportbahn und insbesondere die maximale Breite eines darauf transportierten Produkts abgedeckt und homogen mit Mikrowellen bestrahlt werden.

Es wird als besonders vorteilhaft erachtet, dass die Mikrowellenabstrahleinrichtung eine vorgegebene Anzahl von Koaxialleitern mit jeweils mindestens einer Öffnung aufweist, so dass über eine Behandlungslänge der Transportbahn hinweg die in Transportrichtung hintereinander angeordneten Öffnungen ein über die Transportbahn transportiertes Produkt in einer quer zur Transportrichtung verlaufenden Querrichtung vollständig abdecken.

Für viele Produkte, insbesondere für Lebensmittel und Fertiggerichte, können Mikrowellen mit einer Frequenz von 2,45 GHz für eine Haltbarmachung oder Sterilisierung der Produkte verwendet werden. Die Mikrowellen weisen dann eine Wellenlänge von etwa 12 cm auf. Werden andere Frequenzen für die eingekoppelten Mikrowellen verwendet, wie beispielsweise 915 MHz oder 5,8 GHz, ändert sich deren Wellenlänge entsprechend. Die zweckmäßigerweise hinsichtlich Ihrer Abmessungen jeweils an die betreffende Wellenlänge angepassten Koaxialleiter können sich in axialer Richtung jeweils über mehrere Wellenlängen erstrecken und beispielsweise eine Gesamtlänge von mehr als 50 cm oder mehr als 100 cm aufweisen. In diesen Fällen ist es besonders vorteilhaft, wenn die Koaxialleiter mindestens zwei Öffnungen oder mehr aufweisen.

Im Hinblick auf eine möglichst homogene Bestrahlung eines Produkts mit Mikrowellen ist optional vorgesehen, dass mindestens ein Koaxialleiter auf einer ersten Seite der Transportbahn und mindestens ein weiterer Koaxialleiter auf einer der ersten Seite gegenüberliegenden zweiten Seite der Transportbahn angeordnet ist. Die Koaxialleiter können beispielsweise sowohl von links als auch von rechts quer über die Transportbahn hinweg angeordnet und ausgerichtet sein. Es ist bei Produkten, die eine überwiegend flache Form aufweisen, wie beispielsweise bei auf einem tablettartigen oder tellerartigen Behälter zubereiteten Fertiggerichten besonders vorteilhaft, wenn die Koaxialleiter sowohl oberhalb als auch unterhalb der Transportbahn angeordnet sind, und die jeweiligen Öffnungen jeweils zu dem auf der Transportbahn entlang transportierten Produkt hin ausgerichtet sind. Bei hoch aufragenden Produkten können zusätzliche Koaxialleiter seitlich links und rechts von der Transportbahn angeordnet und von der betreffenden Seite aus auf das Produkt einwirken. Auf diese Weise kann das Produkt von mehreren Seiten aus mit Mikrowellen bestrahlt und dadurch gleichmäßig und rasch erwärmt werden.

Gemäß einer besonders vorteilhaften Ausgestaltung des Erfindungsgedankens ist vorgesehen, dass mindestens ein Koaxialleiter mit ersten Abmessungen an eine erste Mikrowellenfrequenz angepasst ist und mindestens ein weiterer Koaxialleiter mit zweiten und von der ersten verschiedenen Abmessungen an eine zweite und von der ersten verschiedenen Mikrowellenfrequenz angepasst ist. Mikrowellen mit unterschiedlichen Mikrowellenfrequenzen dringen unterschiedlich tief in ein Produkt ein und können zu einer unterschiedlich starken lokalen Erwärmung innerhalb des Produkts führen. Insbesondere bei Produkten mit einer inhomogenen Zusammensetzung, beispielsweise bei Fertiggerichten mit unterschiedlichen Zutaten, die auf einem tellerartigen oder tablettartigen Behälter angerichtet sind, kann es von großem Vorteil sein, dass die Bestrahlung des Produkts durch unterschiedliche Mikrowellenfrequenzen innerhalb desselben Behandlungsraums möglich ist. So kann beispielsweise mit einer ersten Anzahl von Koaxialleitern, die mit einer niedrigen Mikrowellenfrequenz gespeist werden, eine großflächige und für einige räumliche Bereiche eines Produkts ausreichende geringe Mikrowellenbestrahlung erfolgen, um mit Koaxialleitern, die an eine zweite höhere Mikrowellenfrequenz angepasst sind, gezielt einzelne Bereiche des Produkts zusätzlich zu bestrahlen, die eine zusätzliche Erwärmung bzw. Behandlung benötigen.

Nachfolgend werden verschiedene Ausführungsbeispiele des Erfindungsgedankens erläutert, die in der Zeichnung dargestellt sind. Es zeigt:
Fig. 1 eine erfindungsgemäße Vorrichtung zur Behandlung eines Produkts mit Mikrowellen, wobei eine Anzahl von Koaxialleitern in einen Behandlungsraum ragen, in welchem das Produkt längs einer Transportbahn in einer Transportrichtung hindurch befördert wird,
Fig. 2 eine perspektivische Ansicht eines einzelnen Koaxialleiters,
Fig. 3 eine Ansicht einer Anordnung von Koaxialleitern, wie sie bei dem in Fig. 1 dargestellten Behandlungsraum eingesetzt werden kann,
Fig. 4 eine Ansicht einer abweichend ausgestalteten Anordnung von Koaxialleitern und
Fig. 5 eine zweite Ansicht einer wiederum abweichend ausgestalteten Anordnung von Koaxialleitern.

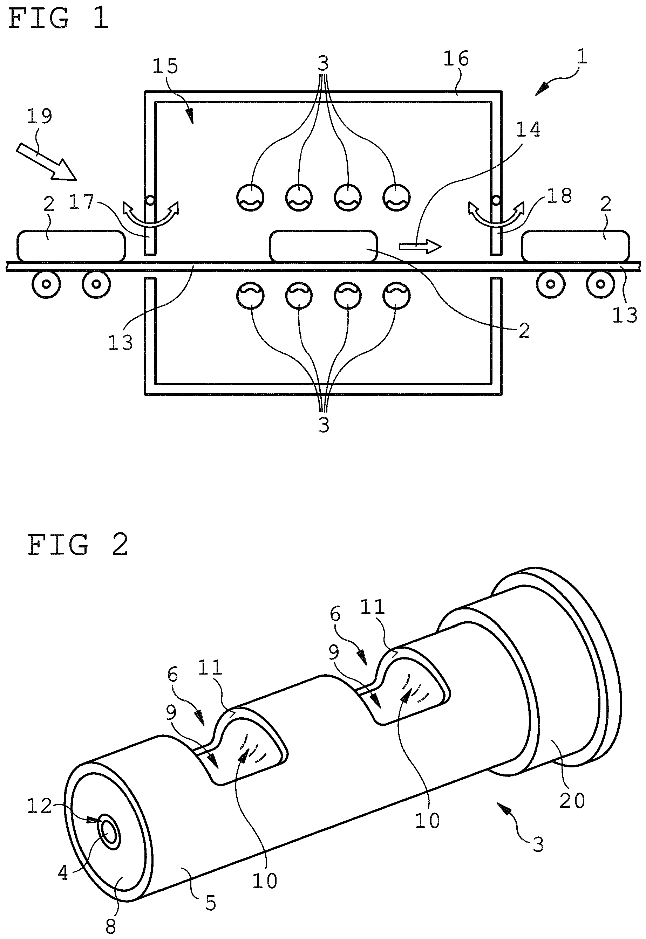

Bei einer in Figur 1 schematisch dargestellten Vorrichtung 1 zur Behandlung eines Produkts 2 mit Mikrowellen umfasst eine Mikrowellenabstrahleinrichtung mehrere Koaxialleiter 3, die bei dem dargestellten Ausführungsbeispiel oberhalb und unterhalb des Produkts 2 angeordnet sind und das Produkt 2 mit Mikrowellen bestrahlen können.

Ein einzelner in Figur 2 beispielhaft dargestellter Koaxialleiter 3 weist einen elektrisch leitenden Innenleiter 4 und einen koaxial um den Innenleiter 4 herum angeordneten hohlzylinderförmigen und elektrisch leitenden Außenleiter 5 auf. Der Koaxialleiter 3 kann in axialer Richtung eine Länge von einigen wenigen Zentimetern bis zu mehr als 50 cm oder 1 m aufweisen. Sowohl die Länge des Koaxialleiters 3 als auch die radialen Abmessungen des Innenleiters 4 und insbesondere des Außenleiters 5 sind dabei zweckmäßigerweise an die Frequenz bzw. Wellenlänge der Mikrowellen angepasst, die während eines Betriebs der Vorrichtung 1 in den Koaxialleiter 3 eingekoppelt werden sollen.

Der Außenleiter 5 weist bei dem in Figur 2 exemplarisch dargestellten Ausführungsbeispiel zwei Öffnungen 6 auf. Der Außenleiter 5 könnte jedoch auch nur eine Öffnung 6 oder aber mehr als zwei Öffnungen 6 aufweisen. Die beiden Öffnungen 6 erstrecken sich in Umfangsrichtung jeweils über etwas weniger als einen halben Umfang des Außenleiters 5. In axialer Richtung sind die beiden Öffnungen 6 bei dem dargestellten Ausführungsbeispiel etwa eine Wellenlänge der während des Betriebs eingespeisten Mikrowellen mit einer vorgegebenen Mikrowellenfrequenz beabstandet. Wenn beispielsweise eine für die Erwärmung von Nahrungsmitteln vorteilhafte Mikrowellenfrequenz von 2,45 GHz verwendet wird, beträgt der Abstand der beiden Öffnungen 6 in axialer Richtung etwa 12 cm.

Zweckmäßigerweise ist ein Abstand zwischen den beiden Öffnungen 6 so gewählt, dass der Abstand ein Vielfaches der halben Wellenlänge der mit der vorgegebenen Mikrowellenfrequenz eingespeisten Mikrowellen beträgt, wobei jede der Öffnungen 6 im Bereich eines elektrischen Feldstärkeknotens angeordnet ist. Die Länge des Koaxialleiters 3 ist dabei in vorteilhafterweise so vorgegeben, dass die eingekoppelten Mikrowellen eine stehende Welle in dem Koaxialleiter 3 bildet.

Zwischen dem Innenleiter 4 und dem Außenleiter 5 ist ein hohlzylinderförmiger dielektrischer Festkörper 8 angeordnet. Der dielektrische Festkörper 8 besteht beispielsweise aus Polyethylen oder aus Polytetrafluorethylen und weist eine deutlich höhere Permittivität als Luft sowie eine vergleichsweise geringe dielektrische Verlustleistung für die eingekoppelten Mikrowellen auf. Der dielektrische Festkörper 8 erhöht zudem die mechanische Festigkeit des Koaxialleiters 3.

In einem durch die Öffnungen 6 des Außenleiters 5 vorgegebenen Bereich weist der Festkörper 8 jeweils eine nach innen ragende Ausformung 9 auf. Eine Formgebung der Ausformungen 9 ist insbesondere in einem Übergangsbereich 10 längs eines Umfangsrandes 11 der Öffnungen 6 so ausgestaltet, dass eine möglichst effektive Auskopplung der Mikrowellen aus dem Koaxialleiter 3 durch die Öffnungen 6 hindurch in die Umgebung ermöglicht wird.

Zwischen dem Innenleiter 4 und dem umgebenden dielektrischen Festkörper 8 ist ein kleiner Ringspalt 12 vorgesehen, um einerseits toleranzbedingte Schwankungen der jeweiligen Abmessungen während der Herstellung des Koaxialleiters 3 ausgleichen zu können und andererseits während eines Betriebs die unterschiedlichen Ausdehnungen des Innenleiters 4 und des dielektrischen Festkörpers 8 auf Grund der unterschiedlichen thermischen Ausdehnungskoeffizienten der jeweils verwendeten Materialien ausgleichen zu können.

Bei der in Figur 1 dargestellten Vorrichtung 1 wird das Produkt 2 auf einer Transportbahn 13 längs einer durch einen Pfeil 14 angedeuteten Transportrichtung durch einen Behandlungsraum 15 transportiert. Die Transportbahn 13 kann beispielsweise ein in die Transportrichtung 14 bewegbares oder umlaufendes Förderband sein, auf welchem das Produkt 2 transportiert wird. Die Transportbahn 13 kann auch eine durch ein Rahmengestell oder eine bahnförmige Plattform vorgegebene Aufstandsfläche sein, auf welcher das Produkt 2 mit Hilfe von Transportvorrichtungen wie beispielsweise von außen bewegten oder selbstttätig fahrenden Produktträgern in der Transportrichtung 14 transportiert wird. Das Produkt 2 kann auch durch geeignete Manipulatoren wie beispielsweise Roboterarme, Greifvorrichtungen oder beispielsweise mit Druck oder Unterdruck beaufschlagbare Transportröhren längs der Transportbahn 13 transportiert werden. Bei der exemplarisch dargestellten Vorrichtung handelt es sich bei der Transportbahn 13 um ein in Transportrichtung 14 verlagerbares Förderband.

Der Behandlungsraum 15 ist von einem Gehäuse 16 umgeben, wobei das Produkt 2 auf der Transportbahn 13 durch eine erste nur schematisch dargestellte Schleuseneinrichtung 17 in den Behandlungsraum 15 hineintransportiert und durch eine zweite Schleuseneinrichtung 18 aus dem Behandlungsraum hinaustransportiert werden kann. Das den Behandlungsraum 15 umgebende Gehäuse 16 und die Schleuseneinrichtungen 17, 18 sind zweckmäßigerweise so ausgestaltet, dass während einer Behandlung des Produkts 2 mit Mikrowellen, die von den Koaxialleitern 3 abgestrahlt werden, kein nennenswerter Anteil der in dem Behandlungsraum 15 abgestrahlten Mikrowellenleistung nach außen dringen kann.

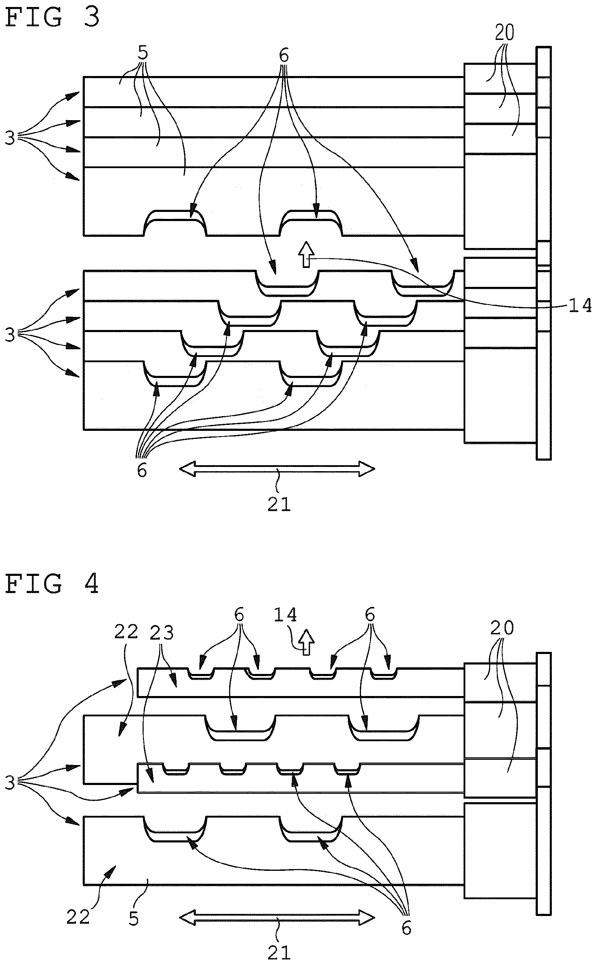

Bei dem in Figur 1 dargestellten Ausführungsbeispiel sind oberhalb der Transportbahn 13 und unterhalb der Transportbahn 13 jeweils vier Koaxialleiter 3 angeordnet. Diese Anordnung der Koaxialleiter 3 ist in Figur 3 aus einer in Figur 1 durch einen Pfeil 19 angedeuteten Blickrichtung dargestellt.

Jeder Koaxialleiter 3 ragt quer zur Transportrichtung 14 über die in Figur 3 nicht dargestellte Transportbahn 13. Bei der in Figur 3 gezeigten Ansicht der Koaxialleiter 3 können Mikrowellen jeweils von rechts über eine jeweilige Einkopplungseinrichtung 20 in jeden der Koaxialleiter 3 eingekoppelt werden. Die zunächst sich längs der Koaxialleiter 3 ausbreitenden Mikrowellen werden durch die Öffnungen 6 in Richtung des Produkts 2 abgestrahlt, das ebenfalls nicht dargestellt ist und sich zwischen den beiden Reihen der Koaxialleiter 3 befindet. Eine maximale Breite des Produkts 2 ist durch einen Längenpfeil 21 angedeutet. Die Koaxialleiter 3 erstrecken sich in axialer Richtung der Koaxialleiter 3 bzw. quer zur Transportrichtung 14 jeweils über die maximale Breite 21 des Produkts 2 hinweg.

Die beiden Öffnungen 6 von in Transportrichtung 14 aufeinanderfolgenden Koaxialleitern 3 sind jeweils quer zur Transportrichtung 14 relativ zueinander versetzt angeordnet. Auf diese Weise kann trotz eines Abstands der beiden Öffnungen 6 eines einzelnen Koaxialleiters 3 das Produkt 2 während seiner Transportbewegung längs der Transportrichtung 14 in jedem Bereich von den aufeinanderfolgenden Öffnungen 6 nacheinander, jedoch sehr homogen mit Mikrowellen bestrahlt und dadurch behandelt, bzw. erwärmt werden. Die in Transportrichtung 14 aufeinanderfolgenden Öffnungen 6 sind so angeordnet, dass die jeweils dem Produkt 2 zugewandten Öffnungsflächen der Öffnungen 6 quer zur Transportrichtung 14 die Breite 21 des Produkts 2 vollständig und lückenlos abdecken.

Bei einem in Figur 4 exemplarisch dargestellten Ausführungsbeispiel weist eine Anordnung von vier Koaxialleitern 3, die beispielsweise bei der in Figur 1 dargestellten Vorrichtung 1 sowohl oberhalb als auch unterhalb der Transportbahn 13 angeordnet sein kann, zwei verschiedene Arten 22, 23 von Koaxialleitern 3 auf. Die erste Art 22 der Koaxialleiter 3 umfasst zwei Koaxialleiter 3, die hinsichtlich der jeweiligen Abmessungen an eine Einkopplung von Mikrowellen mit einer Mikrowellenfrequenz von 2.45 GHz angepasst sind, sodass sich in den Koaxialleitern 3 jeweils eine stehende Welle mit einer charakteristischen Wellenlänge von etwa 6 cm ausbildet, wobei die Anordnung der beiden Öffnungen 6 in elektrischen Feldstärkeknoten der stehenden Welle vorgegeben ist. Die zweite Art 23 der Koaxialleiter 3 umfasst zwei Koaxialleiter 3, die hinsichtlich der jeweiligen Abmessungen an eine Einkopplung von Mikrowellen mit einer Mikrowellenfrequenz von 5,8 GHz angepasst sind, sodass sich in den Koaxialleitern 3 jeweils eine stehende Welle mit einer charakteristischen Wellenlänge von etwas mehr als 5 cm ausbildet, wobei die Anordnung von jeweils vier Öffnungen 6 in elektrischen Feldstärkeknoten der stehenden Welle vorgegeben ist.

Mit einer derartigen Anordnung von zwei Arten 22, 23 von Koaxialleitern 3 kann das an den Koaxialleitern 3 vorbeitransportierte Produkt sehr homogen mit Mikrowellen mit zwei verschiedenen Wellenlängen bestrahlt werden. Die Mikrowellen dringen je nach Wellenlänge unterschiedlich tief in das Produkt 2 ein und können unterschiedlich stark fokussiert bzw. mit unterschiedlicher Intensität betrieben werden. Auf diese Weise können auch inhomogene Produkte 2 durch eine geeignete Auswahl von verschiedenen Arten 22, 23 von Koaxialleitern 3 und eine geeignete Vorgabe der jeweiligen Anzahl und Ausrichtung der Koaxialleiter 3 sehr gleichmäßig behandelt und beispielsweise innerhalb kurzer Verweildauer in dem Behandlungsraum 15 sehr homogen erhitzt werden. Es können auch mehr als zwei verschiedene Arten 22, 23 von Koaxialleitern 3, die jeweils an unterschiedliche Wellenlängen der eingekoppelten Mikrowellenstrahlung angepasst sind, mit jeweils unterschiedlicher Anzahl und Anordnung miteinander kombiniert werden.

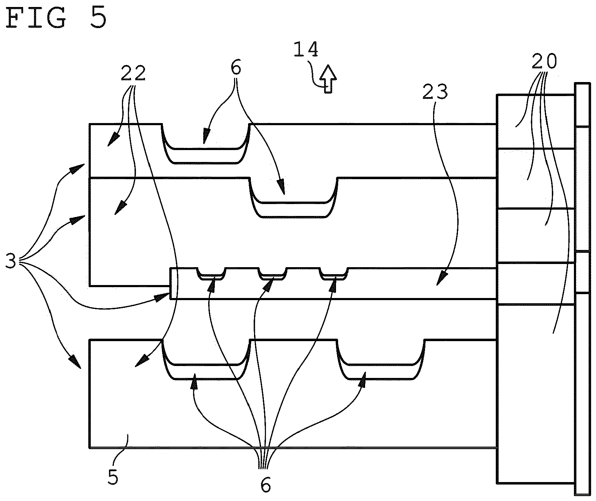

In Figur 5 ist lediglich beispielhaft eine wiederum abweichende Anordnung von Koaxialleitern 3 dargestellt, die insbesondere für die Behandlung von inhomogenen Produkten 2 vorteilhaft eingesetzt werden kann. Die Anordnung umfasst Koaxialleiter 3 von zwei verschiedenen Arten 22, 23. Die einzelnen Koaxialleiter 3 weisen eine unterschiedliche Anzahl von Öffnungen 6 auf, die nicht gleichmäßig über die maximale Breite des zu behandelnden Produkts 2 verteilt angeordnet sind. Bei der in Figur 5 gewählten Ansicht aus der in Figur 1 gezeigten Blickrichtung 19 kann das an den Koaxialleitern 3 in der Transportrichtung 14 vorbeitransportierte Produkt 2 auf der linken Seite des Produkts 2 wesentlich intensiver mit Mikrowellen bestrahlt werden und ein inhomogenes Produkt 2, das auf der linken Seite wesentlich schwerer durch Mikrowellen erhitzt werden kann, dennoch nach Ablauf der Behandlungsdauer bzw. nach dessen Transport an den Koaxialleitern 3 vorbei über das gesamte Produkt 2 hinweg auf eine gleichmäßige Temperatur erhitzt ist.

## Patentansprüche

1. Vorrichtung (1) zur Behandlung eines Produkts (2) mit Mikrowellen, wobei die Vorrichtung (1) einen Behandlungsraum (15), in welchem das Produkt (2) längs einer Transportbahn (13) in einer Transportrichtung (14) durch den Behandlungsraum (15) befördert werden kann, und eine in dem Behandlungsraum (15) angeordnete Mikrowellenabstrahleinrichtung aufweist, mit welcher in die Mikrowellenabstrahleinrichtung eingekoppelte Mikrowellen abgestrahlt werden können, die auf das Produkt (2) einwirken, wobei die Mikrowellenabstrahleinrichtung mindestens einen in den Behandlungsraum (15) ragenden oder darin angeordneten Koaxialleiter (3) mit einem elektrisch leitenden Innenleiter (4) und mit einem elektrisch leitenden Außenleiter (5) aufweist, wobei der Außenleiter (5) koaxial angeordnet den Innenleiter (4) beabstandet umgibt und mindestens eine Öffnung (6) aufweist, die eine Abstrahlung von Mikrowellen durch die Öffnung (6) hindurch von dem Koaxialleiter (3) auf das Produkt (2) ermöglicht, und wobei die Mikrowellenabstrahleinrichtung mehrere in Transportrichtung (14) beabstandet zueinander angeordnete Koaxialleiter (3) mit jeweils mindestens einer Öffnung (6) in dem jeweiligen Außenleiter (5) aufweist, **dadurch gekennzeichnet, dass** bei einem in Transportrichtung (14) nachfolgend angeordneten Koaxialleiter (3) die mindestens eine Öffnung (6) quer zur Transportrichtung (14) versetzt zu der mindestens einen Öffnung (6) eines vorausgehenden Koaxialleiters (3) angeordnet ist, und wobei die einzelnen Koaxialleiter hinsichtlich der durch jeden Koaxialleiter abgestrahlten Mikrowellenleistung an die insgesamt gewünschte bzw. vorgegebene Mikrowellenleistung angepasst werden können.

2. Vorrichtung (1) nach Anspruch 1, **dadurch gekennzeichnet, dass** die Mikrowellenabstrahleinrichtung eine vorgegebene Anzahl von Koaxialleitern (3) mit jeweils mindestens einer Öffnung (6) aufweist, sodass über eine Behandlungslänge der Transportbahn (13) hinweg die in Transportrichtung (14) hintereinander angeordneten Öffnungen (6) ein über die Transportbahn (13) transportiertes Produkt (2) in einer quer zur Transportrichtung (14) verlaufenden Querrichtung vollständig abdecken.

3. Vorrichtung (1) nach einem der vorangehenden Ansprüche, **dadurch gekennzeichnet, dass** jeder Koaxialleiter (3) mindestens zwei Öffnungen (6) aufweist.

4. Vorrichtung (1) nach einem der vorangehenden Ansprüche, **dadurch gekennzeichnet, dass** mindestens ein Koaxialleiter (3) auf einer ersten Seite der Transportbahn (13) und mindestens ein weiterer Koaxialleiter (3) auf einer der ersten Seite gegenüberliegenden zweiten Seite der Transportbahn (13) angeordnet ist.

5. Vorrichtung (1) nach einem der vorangehenden Ansprüche, **dadurch gekennzeichnet, dass** mindestens ein Koaxialleiter (3) mit ersten Abmessungen an eine erste Mikrowellenfrequenz angepasst ist und mindestens ein weiterer Koaxialleiter (3) mit zweiten und von den ersten verschiedenen Abmessungen an eine zweite und von der ersten verschiedenen Mikrowellenfrequenz angepasst ist.

## Claims

1. Device (1) for treating a product (2) with microwaves, wherein the device (1) comprises a treatment chamber (15), in which the product (2) can be transported along a transport path (13) in a transport direction (14) through the treatment chamber (15), and comprises a microwave-radiation apparatus arranged in the treatment chamber (15), by means of which microwaves coupled into the microwave-radiation apparatus which act on the product (2) can be radiated, wherein the microwave-radiation apparatus comprises at least one coaxial conductor (3) which protrudes into the treatment chamber (15) or is arranged therein and has an electrically conductive internal conductor (4) and an electrically conductive external conductor (5), wherein the external conductor (5) surrounds the internal conductor (4) so as to be spaced apart therefrom and arranged coaxially and comprises at least one opening (6), which enables microwaves to be emitted from the coaxial conductor (3) through the opening (6) onto the product (2), and wherein the microwave-radiation apparatus comprises a plurality of coaxial conductors (3), which are arranged so as to be spaced apart from one another in the transport direction (14) and each have at least one opening (6) in the relevant external conductor (5), **characterised in that**, in a coaxial conductor (3) arranged consecutively in the transport direction (14), the at least one opening (6) is arranged to be offset, transversely to the transport direction (14), from the at least one opening (6) in a preceding coaxial conductor (3), and wherein the individual coaxial conductors can be adapted, in respect of the microwave power that is emitted by each coaxial conductor, to the microwave power that is desired or predetermined overall.

2. Device (1) according to claim 1, **characterised in that** the microwave-radiation apparatus comprises a predetermined number of coaxial conductors (3) that each have at least one opening (6), such that the openings (6) arranged successively in the transport direction (14) completely cover a product (2) transported via the transport path (13) in a transverse direction extending transversely to the transport direction (14) across a treatment length of the transport path (13).

3. Device (1) according to any of the preceding claims, **characterised in that** each coaxial conductor (3) comprises at least two openings (6).

4. Device (1) according to any of the preceding claims, **characterised in that** at least one coaxial conductor (3) is arranged on a first side of the transport path (13) and at least one further coaxial conductor (3) is arranged on a second side of the transport path (13) opposite the first side.

5. Device (1) according to any of the preceding claims, **characterised in that** at least one coaxial conductor (3) having first dimensions is adapted to a first microwave frequency and at least one further coaxial conductor (3) having second dimensions that are different from the first dimensions is adapted to a second microwave frequency that is different from the first microwave frequency.

## Revendications

1. Dispositif (1) pour le traitement d'un produit (2) avec des micro-ondes, dans lequel le dispositif (1) présente un espace de traitement (15), dans lequel le produit (2) peut être convoyé à travers l'espace de traitement (15) dans une direction de transport (14) le long d'une voie de transport (13), et un système d'émission de micro-ondes disposé dans l'espace de traitement (15), avec lequel peuvent être émises des micro-ondes injectées dans le système d'émission de micro-ondes, qui agissent sur le produit (2), dans lequel le système d'émission de micro-ondes présente au moins un conducteur coaxial (3) dépassant dans l'espace de traitement (15) ou disposé dans celuici, avec un conducteur intérieur (4) électriquement conducteur et avec un conducteur extérieur (5) électriquement conducteur, dans lequel le conducteur extérieur (5) entoure à distance, disposé de manière coaxiale, le conducteur intérieur (4) et présente au moins une ouverture (6), qui permet une émission de micro-ondes à travers l'ouverture (6) par le conducteur coaxial (3) sur le produit (2), et dans lequel le système d'émission de micro-ondes présente plusieurs conducteurs coaxiaux (3) disposés à distance les uns par rapport aux autres dans la direction de transport (14) avec respectivement au moins une ouverture (6) dans le conducteur extérieur (5) respectif, **caractérisé en ce que** l'au moins une ouverture (6) est disposée de manière décalée par rapport à l'au moins une ouverture (6) d'un conducteur coaxial (3) précédent de manière transversale par rapport à la direction de transport (14) lorsqu'un conducteur coaxial (3) est disposé après dans la direction de transport (14), et dans lequel les divers conducteurs coaxiaux peuvent être adaptés à la puissance de micro-ondes globalement souhaitée ou spécifiée eu égard à la puissance de micro-ondes émise par chaque conducteur coaxial.

2. Dispositif (1) selon la revendication 1, **caractérisé en ce que** le système d'émission de micro-ondes présente un nombre spécifié de conducteurs coaxiaux (3) avec respectivement au moins une ouverture (6) de sorte que les ouvertures (6) disposées les unes derrière les autres dans la direction de transport (14) recouvrent en totalité dans une direction transversale s'étendant de manière transversale par rapport à la direction de transport (14) un produit (2) transporté sur la voie de transport (13) au-delà d'une longueur de traitement de la voie de transport (13) .

3. Dispositif (1) selon l'une quelconque des revendications précédentes, **caractérisé en ce que** chaque conducteur coaxial (3) présente au moins deux ouvertures (6).

4. Dispositif (1) selon l'une quelconque des revendications précédentes, **caractérisé en ce qu'**au moins un conducteur coaxial (3) est disposé sur un premier côté de la voie de transport (13) et au moins un autre conducteur coaxial (3) est disposé sur un deuxième côté, faisant face au premier côté, de la voie de transport (13).

5. Dispositif (1) selon l'une quelconque des revendications précédentes, **caractérisé en ce qu'**au moins un conducteur coaxial (3) est adapté par des premières dimensions à une première fréquence de micro-ondes et au moins un autre conducteur coaxial (3) est adapté par des deuxièmes dimensions différentes des premières, à une deuxième fréquence de micro-ondes différente de la première.
